(19) Europäisches Patentamt
European Patent Office
Office européen des brevets

(11) **EP 3 712 221 A1**

(12) **EUROPEAN PATENT APPLICATION**

(43) Date of publication:
**23.09.2020 Bulletin 2020/39**

(51) Int Cl.:
*C09J 7/25* (2018.01)          *H01L 21/683* (2006.01)

(21) Application number: **20163866.5**

(22) Date of filing: **18.03.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.03.2019  JP 2019054573**

(71) Applicant: **Nitto Denko Corporation
Ibaraki-shi, Osaka 567-8680 (JP)**

(72) Inventor: **KONO, Hiroki
Ibaraki-shi, Osaka 567-8680 (JP)**

(74) Representative: **Grünecker Patent- und
Rechtsanwälte
PartG mbB
Leopoldstraße 4
80802 München (DE)**

(54) **BACKGRINDING TAPE**

(57)    Provided is a backgrinding tape that is excellent in heat resistance and can be suitably used even in a high-vacuum and high-temperature process. The backgrinding tape includes: a base material; and a pressure-sensitive adhesive layer formed on one surface of the base material. The base material has a flexural rigidity of 0.2 N·mm² or more, and a light transmittance of 10% or more at a wavelength of 400 nm, and a resin forming the base material has a melting point of 200°C or more.

[Fig.1]

**Description**

BACKGROUND OF THE INVENTION

1. Field of the Invention

The present invention relates to a backgrinding tape.

2. Description of the Related Art

A semiconductor wafer is produced so as to be in a large-diameter state, and after a pattern has been formed on its front surface, its back surface is ground (subjected to backgrinding) so that the thickness of the wafer may be typically reduced to from about 40 $\mu$m to about 600 $\mu$m. Next, a wet etching step is performed for, for example, adjusting a semiconductor wafer surface, and the ground semiconductor wafer is cut and separated (diced) into small element pieces. After that, the small element pieces are further transferred to a mounting step. Thus, a desired semiconductor element is obtained. In the backgrinding step, a pressure-sensitive adhesive tape (backgrinding tape) is used for fixing the semiconductor wafer or protecting a surface opposite to its surface to be ground (e.g., Japanese Patent Application Laid-open No. 2011-151163).

In a production process for an insulated gate bipolar transistor (IGBT) or the like, to improve the characteristics of the device, a backgrinding step may be performed until the thickness of the wafer becomes 100 $\mu$m or less. When the wafer is ground into such a thin shape, a UV-curable pressure-sensitive adhesive tape that is lightly peelable is used. A semiconductor wafer is subjected to the backgrinding step, and is then subjected to an ashing step of removing its resist. In the ashing step, the wafer is placed in a state having a high degree of vacuum and a temperature as high as 200°C or more. Accordingly, the base material of the pressure-sensitive adhesive tape to be used may deform, or delamination may occur between the semiconductor wafer and the pressure-sensitive adhesive layer of the tape. As a result, the following problems may occur. The wafer does not satisfactorily adsorb to a stage, and the pressure-sensitive adhesive tape is not satisfactorily peeled.

SUMMARY OF THE INVENTION

The present invention has been made to solve the conventional problems, and a primary object of the present invention is to provide a backgrinding tape that is excellent in heat resistance and can be suitably used even in a high-vacuum and high-temperature process .

According to at least one embodiment of the present invention, there is provided a backgrinding tape, including: a base material; and a pressure-sensitive adhesive layer formed on one surface of the base material. The base material has a flexural rigidity of 0.2 N·mm$^2$ or more, and a light transmittance of 10% or more at a wavelength of 400 nm, and a resin forming the base material has a melting point of 200°C or more.

In at least one embodiment, the base material has a tensile modulus of elasticity of 1,500 MPa or more.

In at least one embodiment, the base material has a thickness of from 30 $\mu$m to 200 $\mu$m.

In at least one embodiment, the resin forming the base material includes at least one selected from the group consisting of a polyethylene terephthalate resin, a polyimide-based resin, a polyether ether ketone resin, a polyamide-imide resin, a polyethylene naphthalate resin, a polyphenyl sulfide resin, and a polyether-imide resin.

In at least one embodiment, the pressure-sensitive adhesive layer is formed of an active energy ray-curable pressure-sensitive adhesive composition.

According to at least one embodiment of the present invention, the backgrinding tape that is excellent in heat resistance and can be suitably used even in a high-vacuum and high-temperature process is provided. The backgrinding tape according to at least one embodiment of the present invention includes: a base material; and a pressure-sensitive adhesive layer formed on one surface of the base material. The base material has a flexural rigidity of 0.2 N·mm$^2$ or more, and a light transmittance of 10% or more at a wavelength of 400 nm, and a resin forming the base material has a melting point of 200°C or more. When the backgrinding tape including such base material is used, even in the case where a wafer is subjected to high-vacuum and high-temperature ashing treatment, the occurrence of delamination between the wafer and the pressure-sensitive adhesive layer is prevented, and even in the case where a lightly peelable pressure-sensitive adhesive layer of, for example, an active energy ray-curable pressure-sensitive adhesive composition is formed, its characteristics can be satisfactorily maintained. In addition, an inconvenience, such as insufficient adsorption of the wafer to a stage, can be prevented.

BRIEF DESCRIPTION OF THE DRAWINGS

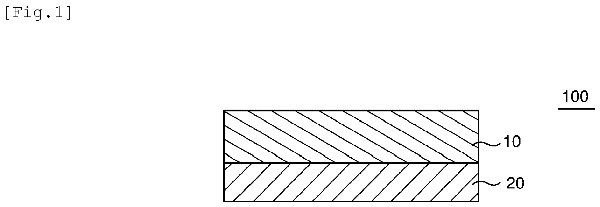

FIG. 1 is a schematic sectional view of a backgrinding tape according to at least one embodiment of the present invention.

DESCRIPTION OF THE EMBODIMENTS

Embodiments of the present invention are described below. However, the present invention is not limited to these embodiments.

A. Overall Configuration of Backgrinding Tape

FIG. **1** is a schematic sectional view of a backgrinding tape according to at least one embodiment of the present invention. A backgrinding tape **100** in the illustrated example includes a base material **20** and a pressure-sensitive adhesive layer **10** formed on one surface of the base material **20**. In practical use, until the tape is used, a separator is temporarily bonded to the pressure-sensitive adhesive layer **10** in a peelable manner for appropriately protecting the pressure-sensitive adhesive layer **10**. In the backgrinding tape **100,** after the step of producing a semiconductor wafer has been ended, the pressure-sensitive adhesive layer **10** is typically irradiated with an active energy ray. Thus, the pressure-sensitive adhesive layer cures to be reduced in pressure-sensitive adhesive strength, and hence the tape is peeled from an adherend (the semiconductor wafer).

In addition, the surface of the base material 20 on which the pressure-sensitive adhesive layer is formed may be subjected to any appropriate surface treatment in accordance with purposes. Examples of the surface treatment include chromic acid treatment, ozone exposure, flame exposure, high voltage electric shock exposure, ionizing radiation treatment, matting treatment, corona discharge treatment, primer treatment, and cross-linking treatment.

The base material **20** has a flexural rigidity of 0.2 N·mm$^2$ or more, and a light transmittance of 10% or more at a wavelength of 400 nm, and a resin forming the base material has a melting point of 200°C or more. In addition, the thickness of the base material **20** is preferably from 30 $\mu$m to 200 $\mu$m, more preferably from 50 $\mu$m to 175 $\mu$m. When the backgrinding tape includes such base material, its heat resistance is improved, and hence even in the case where a wafer is subjected to high-vacuum and high-temperature ashing treatment, the occurrence of delamination between the wafer and the pressure-sensitive adhesive layer can be prevented.

The thickness of the backgrinding tape **100** may be set to any appropriate thickness. The thickness of the backgrinding tape **100** is preferably from 40 $\mu$m to 500 $\mu$m, more preferably from 150 $\mu$m to 400 $\mu$m. When the thickness of the backgrinding tape **100** falls within the range, the tape can be suitably used in a backgrinding step for a semiconductor wafer.

The thickness of the pressure-sensitive adhesive layer **10** is preferably from 10 $\mu$m to 300 $\mu$m, more preferably from 15 $\mu$m to 200 $\mu$m.

B. Pressure-sensitive Adhesive Layer

The pressure-sensitive adhesive layer may be formed by using any appropriate pressure-sensitive adhesive composition. The pressure-sensitive adhesive composition is preferably an active energy ray-curable pressure-sensitive adhesive composition. The active energy ray-curable pressure-sensitive adhesive composition may be reduced in pressure-sensitive adhesive strength by being irradiated with an active energy ray. The use of the active energy ray-curable pressure-sensitive adhesive composition can provide a lightly peelable backgrinding tape. Examples of the active energy ray include a gamma ray, UV light, visible light, an infrared ray (heat ray), a radio wave, an alpha ray, a beta ray, an electron beam, a plasma flow, an ionizing ray, and a particle beam. Of those, UV light is preferred.

A base polymer in the pressure-sensitive adhesive composition is, for example, an acrylic resin having a curable functional group in at least one of the following positions: in a side chain thereof, in its main chain, or at a terminal of the main chain, rubber-based resin, silicon-based resin, or polyvinyl ether-based resin. In addition, the pressure-sensitive adhesive composition may contain a curable monomer component and/or a curable oligomer component. The curable monomer component and/or the curable oligomer component may be added to the pressure-sensitive adhesive composition containing the base polymer having a curable functional group.

Any appropriate acrylic resin may be used as the acrylic resin. An example of the acrylic resin is a resin containing a (meth) acrylic acid ester as a main monomer component. Examples of the (meth)acrylic acid ester include: (meth)acrylic acid alkyl esters each including a linear or branched alkyl group having 1 to 30 carbon atoms, such as a methyl ester, an ethyl ester, a propyl ester, an isopropyl ester, a butyl ester, an isobutyl ester, a sec-butyl ester, a t-butyl ester, a pentyl ester, an isopentyl ester, a hexyl ester, a heptyl ester, an octyl ester, a 2-ethylhexyl ester, an isooctyl ester, a nonyl ester, a decyl ester, an isodecyl ester, an undecyl ester, a dodecyl ester, a tridecyl ester, a tetradecyl ester, a hexadecyl ester, an octadecyl ester, and an eicosyl ester; and (meth) acrylic acid cycloalkyl esters, such as a cyclopentyl ester and a cyclohexyl ester. Those monomers may be used alone or in combination thereof.

The acrylic resin may contain, as a monomer component, another copolymerizable monomer copolymerizable with the (meth)acrylic acid ester as required. Examples of the other copolymerizable monomer include: carboxyl group or acid anhydride group-containing monomers, such as acrylic acid, methacrylic acid, itaconic acid, fumaric acid, and maleic anhydride; hydroxyl group-containing monomers, such as 2-hydroxyethyl (meth)acrylate; amino group-containing monomers, such as morpholyl (meth)acrylate; and amide group-containing monomers, such as (meth)acrylamide. The content of a constituent unit derived from the copolymerizable monomer is preferably 20 parts by weight or less, more preferably 15 parts by weight or less, still more preferably from 2.5 parts by weight to 10 parts by weight with respect to 100 parts by weight of the base polymer.

The acrylic resin may contain, as a monomer component, a hydroxyl group-containing monomer copolymerizable with the acrylic acid ester. Examples of the hydroxyl group-containing monomer include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)methyl (meth)acrylate. The hydroxyl group-containing monomers may be used alone or in combination thereof.

The acrylic resin may be obtained through the polymerization of the monomer component by any appropriate polymerization method. Examples of the polymerization method include solution polymerization, emulsion polymerization, bulk polymerization, and suspension polymerization.

The pressure-sensitive adhesive composition may further contain an isocyanate-based compound having a curable functional group in a molecule thereof. Examples of the isocyanate-based compound include methacryloyl isocyanate, 2-methacryloyloxyethyl isocyanate, 2-acryloyloxyethyl isocyanate, and m-isopropenyl-$\alpha,\alpha$-dimethylbenzyl isocyanate.

Any appropriate compound may be used as the curable monomer component and oligomer component. Examples thereof include the isocyanate-based compound, a urethane oligomer, urethane (meth)acrylate, trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxypenta(meth)acrylate, dipentaerythritol hexa(meth)acrylate, and 1,4-butanediol di(meth)acrylate.

The weight-average molecular weight of the base polymer is preferably from 200,000 to 3,000,000, more preferably from 250,000 to 1,500,000. The weight-average molecular weight may be measured by GPC (solvent: THF).

The glass transition temperature of the base polymer is preferably from -70°C to -20°C, more preferably from -60°C to -40°C.

The pressure-sensitive adhesive composition may further contain any appropriate additive. Examples of the additive include a polymerization initiator, a cross-linking agent, a polymerization inhibitor, a curing aid, a plasticizer, a tackifier, an age inhibitor, a filler, a colorant, an antistatic agent, and a surfactant. The additives may be used alone or in combination thereof. When two or more kinds of additives are used, the additives may be added one by one, or the two or more kinds of additives may be simultaneously added. The compounding amount of the additive may be set to any appropriate amount.

Any appropriate cross-linking agent may be used as the cross-linking agent. Examples thereof include an isocyanate-based cross-linking agent, an epoxy-based cross-linking agent, a melamine-based cross-linking agent, a peroxide-based cross-linking agent, a urea-based cross-linking agent, a metal alkoxide-based cross-linking agent, a metal chelate-based cross-linking agent, a metal salt-based cross-linking agent, a carbodiimide-based cross-linking agent, an oxazoline-based cross-linking agent, an aziridine-based cross-linking agent, and an amine-based cross-linking agent. The cross-linking agents may be used alone or in combination thereof. The usage amount of the cross-linking agent may be set to any appropriate value in accordance with applications where the backgrinding tape is used. The usage amount of the cross-linking agent is preferably 20 parts by weight or less, more preferably from 0.1 part by weight to 6 parts by weight with respect to 100 parts by weight of the base polymer.

Any appropriate plasticizer may be used as the plasticizer. Examples thereof include a carboxylic acid ester-based plasticizer, such as a phthalic acid ester-based plasticizer, a trimellitic acid ester-based plasticizer, a pyromellitic acid ester-based plasticizer, or an adipic acid ester-based plasticizer, a phosphoric acid-based plasticizer, an epoxy-based plasticizer, and a polyester-based plasticizer (e.g., low-molecular-weight polyester). The usage amount of the plasticizer is preferably 30 parts by weight or less, more preferably from 0.1 part by weight to 25 parts by weight, still more preferably from 0.1 part by weight to 15 parts by weight with respect to 100 parts by weight of the base polymer.

C. Base Material

The base material **20** has a flexural rigidity of 0.2 N·mm$^2$ or more, and a light transmittance of 10% or more at a wavelength of 400 nm. A resin forming the base material **20** has a melting point of 200°C or more. When the backgrinding tape includes such base material, its heat resistance is improved, and hence the tape can be suitably used even in high-vacuum and high-temperature treatment.

The flexural rigidity of the base material is 0.2 N·mm$^2$ or more, preferably 0.21 N·mm$^2$ or more, more preferably 0.23 N·mm$^2$ or more. In addition, the flexural rigidity of the base material is preferably 75 N·mm$^2$ or less, more preferably 45 N·mm$^2$ or less. When the flexural rigidity falls within the range, even in the case where the backgrinding tape is placed under a high-vacuum and high-temperature environment, the occurrence of delamination between the adherend (semiconductor wafer) and the pressure-sensitive adhesive layer can be suppressed. The term " flexural rigidity " as used herein refers to a value calculated from the following equation:

$$I = E \times w \times h^3 / 12$$

(where I represents the flexural rigidity (N·mm$^2$) of a test piece, E represents the tensile modulus of elasticity (MPa) of the test piece, "w" represents the width (mm) of the test piece, and "h" represents the thickness (mm) of the test piece).

The light transmittance of the base material at a wavelength of 400 nm is 10% or more, preferably 30% or more, more preferably 50% or more. In the case where the light transmittance at a wavelength of 400 nm falls within the range, when a pressure-sensitive adhesive that is curable with an active energy ray (preferably UV light) is used as the pressure-sensitive adhesive composition forming the pressure-sensitive adhesive layer, the pressure-sensitive adhesive layer can be more satisfactorily cured, and hence the backgrinding tape can be more easily peeled. The light transmittance at a wavelength of 400 nm only needs to be 10% or more, and there is no upper limit thereof. The light transmittance of the base material at a wavelength of 400 nm may be measured with a UV-visible spectrophotometer (e.g., a product available under the product name "SolidSpec-3700" from Shimadzu Corporation).

The tensile modulus of elasticity of the base material is preferably 1,500 MPa or more, more preferably 1,800 MPa or more, still more preferably 2,000 MPa or more. In addition, the tensile modulus of elasticity of the base material is preferably 50,000 MPa or less, more preferably 30,000 MPa or less. When the tensile modulus of elasticity falls within the range, the occurrence of the delamination between the adherend (semiconductor wafer) and the pressure-sensitive adhesive layer under a high-vacuum and high-temperature environment can be suppressed. The term "tensile modulus of elasticity" as used herein refers to a value measured in conformity with JIS K 7161.

The base material includes the resin having a melting point of 200°C or more. The melting point of the resin forming the base material is preferably 220°C or more, more preferably 250°C or more. There is no upper limit of the melting point of the resin forming the base material, and a resin that does not melt is permitted. When the melting point of the resin forming the base material falls within the range, the heat resistance of the backgrinding tape can be improved. The melting point of the base material may be measured by differential scanning calorimetry (DSC).

Any appropriate resin having a melting point of 200°C or more may be used as the resin forming the base material. Examples thereof include a polyethylene terephthalate resin, a polyimide-based resin, a polybenzoxazole resin, a polyethylene naphthalate resin, a polyether ether ketone resin, a polyphenyl sulfide resin, a polyether-imide resin, a polyamide-imide resin, a polytetrafluoroethylene fluororesin, a polyvinylidene chloride resin, a polybutylene terephthalate resin, and a polychlorotrifluoroethylene resin. Of those, a polyethylene terephthalate resin, a polyimide-based resin, a polyethylene naphthalate resin, a polyether ether ketone resin, a polyphenyl sulfide resin, a polyether-imide resin, and a polyamide-imide resin are preferably used. When any such resin is used, even in the case where the backgrinding tape is subjected to a heat-resisting step at high temperature (e.g., 200°C or more), the discoloration and/or deformation of the base material can be suppressed.

The base material may be produced by any appropriate method. For example, the base material may be produced by a method such as calender film formation, casting film formation, inflation extrusion, or T-die extrusion. In addition, the base material may be produced by performing stretching treatment as required.

A commercial resin film may be used as the base material. Examples thereof include: a product available under the product name "TEONEX (trademark) Q51" and a product available under the product name "TEONEX (trademark) Q83" from DuPont Teijin Films; a product available under the product name "TORCENA" and a product available under the product name "EXPEEK" from Kurabo Industries Ltd.; and a product available under the product name "TORMED Type X" and a product available under the product name "TORMED Type S" from I.S.T Corporation.

D. Method of producing Backgrinding Tape

The backgrinding tape according to at least one embodiment of the present invention may be produced by applying the above-mentioned pressure-sensitive adhesive composition onto the above-mentioned base material. Various methods, such as bar coater coating, air knife coating, gravure coating, gravure reverse coating, reverse roll coating, lip coating, die coating, dip coating, offset printing, flexo printing, and screen printing, may each be adopted as a method of applying the pressure-sensitive adhesive. In addition, for example, a method involving separately forming the pressure-sensitive adhesive layer on the separator, and then bonding the resultant to the base material may be adopted.

Examples

The present invention is specifically described below by way of Examples, but the present invention is not limited to these Examples. In addition, "part (s) " and "%" in Examples are by weight unless otherwise specified.

<Production Example 1> Preparation of Pressure-sensitive Adhesive Composition

100 Parts by weight of butyl acrylate, 8 parts by weight of 2-hydroxyethyl acrylate, 0.3 part by weight of a polymerization initiator (2,2'-azobis-isobutyronitrile (AIBN)), and a solvent (methyl ethyl ketone (MEK)) were mixed to prepare a monomer composition.
The monomer composition was loaded into an experimental apparatus for polymerization obtained by mounting a 1-liter round-bottom separable flask with a separable cover, a separating funnel, a temperature gauge, a nitrogen-introducing tube, a Liebig condenser, a vacuum seal, a stirring rod, and a stirring blade, and while the composition was stirred, the inside of the apparatus was purged with nitrogen at normal temperature for 6 hours. After that, while the composition was stirred in a stream of nitrogen, the composition was held under 65°C for 6 hours to be polymerized. Thus, a resin solution was obtained.
The resultant resin solution was cooled to room temperature. After that, 4 parts by weight of 2-isocyanatoethyl methacrylate (manufactured by Showa Denko K.K., product name: KARENZ MOI) was added as a compound having a polymerizable carbon-carbon double bond to the resin solution. Further, 0.11 part by weight of dibutyltin(IV) dilaurate (manufactured by Wako Pure Chemical Industries, Ltd.) was added to the mixture, and the whole was stirred under an air atmosphere at 50°C for 24 hours to provide a polymer solution.
100 Parts by weight of the resultant polymer solution was mixed with 1 part by weight of a cross-linking agent (manufactured by Tosoh Corporation, product name: CORONATE L), 1 part by weight of an initiator (manufactured by BASF, product name: IRGACURE 369), 0.1 part by weight of a polymerization inhibitor (manufactured by BASF, product name: IRGANOX 1010), 0.5 part by weight of a curing aid 1 (manufactured by Adeka Corporation, product name: EDP-300), and 2.5 parts by weight of a curing aid 2 (manufactured by Adeka Corporation, product name: EDP-1100). Thus, a pressure-sensitive adhesive composition was obtained.

[Example 1]

A product obtained by subj ecting one surface of a polyethylene naphthalate film 1 (manufactured by DuPont Teijin Films, product name: TEONEX (trademark) Q51", thickness: 50 μm) to corona treatment was used as a base material.
The pressure-sensitive adhesive composition prepared in Production Example 1 was applied to the release-treated surface of a separator (obtained by applying a silicone-based releasing agent to one surface of a polyester-based film (manufactured by Mitsubishi Chemical Corporation, product name: MRF38, thickness: 38 μm)), and was heated at 120°C for 2 minutes to form a pressure-sensitive adhesive layer (thickness: 50 μm).
The corona-treated surface of the base material and the pressure-sensitive adhesive layer formed on the separator were bonded to each other, and the resultant was aged at 50°C for 2 days to provide a backgrinding tape.

[Example 2]

A backgrinding tape was obtained in the same manner as in Example 1 except that a polyester-based film (manufactured by Kurabo Industries Ltd., product name: TORCENA, thickness: 50 μm) was used instead of the polyethylene naphthalate film 1.

[Example 3]

A backgrinding tape was obtained in the same manner as in Example 1 except that a polyisocyanate-based film 1 (manufactured by I.S.T Corporation, product name: TORMED Type X, thickness: 50 μm) was used instead of the polyethylene naphthalate film 1.

(Comparative Example 1)

A backgrinding tape was obtained in the same manner as in Example 1 except that a polyethylene naphthalate film 2 (manufactured by DuPont Teijin Films, product name: TEONEX (trademark) Q83, thickness: 25 μm) was used

instead of the polyethylene naphthalate film 1.

(Comparative Example 2)

A backgrinding tape was obtained in the same manner as in Example 1 except that a polyether ether ketone film (manufactured by Kurabo Industries Ltd., product name: EXPEEK, thickness: 25 $\mu$m) was used instead of the polyethylene naphthalate film 1.

(Comparative Example 3)

A backgrinding tape was obtained in the same manner as in Example 1 except that a polyisocyanate-based film 2 (manufactured by I.S.T Corporation, product name: TORMED Type S, thickness: 25 $\mu$m) was used instead of the polyethylene naphthalate film 1.

(Comparative Example 4)

A backgrinding tape was obtained in the same manner as in Example 1 except that a polyisocyanate-based film 3 (manufactured by Du Pont-Toray Co., Ltd., product name: KAPTON 200V, thickness: 50 $\mu$m) was used instead of the polyethylene naphthalate film 1.

[Evaluation]

The base materials used in Examples and Comparative Examples, or the backgrinding tapes obtained therein were subjected to the following evaluations (1) to (5). The results are shown in Table 1.

(1) Light Transmittance at Wavelength of 400 nm

The light transmittances of the respective films used as the base materials at a wavelength of 400 nm were measured with a UV-visible spectrophotometer (manufactured by Shimadzu Corporation, product name: SolidSpec-3700).

(2) Melting Point

The melting points of the films used as the base materials were measured with a differential scanning calorimeter (manufactured by TA Instruments Inc., product name: Q2000). Such a film that no melting peak was detected even when the film was heated to 400°C was regarded as being undissolvable.

(3) Flexural Rigidity

Each of the films used as the base materials was cut into a size measuring 10 mm wide by 100 mm long, and was used as a test piece. The tensile modulus of elasticity of each of the test pieces was measured in conformity with JIS K 7161. The flexural rigidity of the test piece was calculated from the size of the test piece and the result of the tensile modulus of elasticity thereof by using the following equation:

$$I = E \times w \times h^3 / 12$$

(where I represents the flexural rigidity (N·mm$^2$) of a test piece, E represents the tensile modulus of elasticity (MPa) of the test piece, "w" represents the width (mm) of the test piece, and "h" represents the thickness (mm) of the test piece).

(4) UV Curability

Each of the resultant backgrinding tapes was cut into a width of 20 mm, and was bonded to a silicon mirror wafer, followed by irradiation with light from a high-pressure mercury lamp (70 mW/cm$^2$) for 10 seconds. Next, the pressure-sensitive adhesive strength of the tape was measured by a method in conformity with JIS Z 0237 (2000) (bonding condition: 1 reciprocation of a 2-kilogram roller, peel rate: 300 mm/min, peel angle: 180°). A case in which the pressure-sensitive adhesive strength was less than 1 N/20 mm was indicated by Symbol "○", and a case in which the pressure-sensitive adhesive strength was 1 N/20 mm or more was indicated by Symbol "×".

(5) Heat Resistance

Each of the resultant backgrinding tapes was bonded to a silicon mirror wafer. The resultant product was loaded into a vacuum oven (manufactured by Yamato Scientific Co., Ltd., product name: DP-31), and was placed in a state, which was warmed to 250°C and had a degree of vacuum of 0.1 Torr, for 10 minutes. After that, the product was removed from the vacuum oven, and the presence or absence of delamination between its pressure-sensitive adhesive layer and silicon mirror wafer was visually observed. A product in which no delamination occurred was indicated by Symbol "o", and a product in which the delamination occurred was indicated by Symbol "×".

Table 1

| | Base material | | | | | UV curability | Heat resistance |
|---|---|---|---|---|---|---|---|
| | Thickness ($\mu$m) | Melting point (°C) | Tensile modulus of elasticity (MPa) | Flexural rigidity (N·mm$^2$) | Light transmittance at wavelength of 400 nm (%) | | |
| Example 1 | 50 | 269 | 2,200 | 0.23 | 74 | ○ | ○ |
| Example 2 | 50 | 277 | 2,300 | 0.24 | 88 | ○ | ○ |
| Example 3 | 50 | Undissolvable | 3,300 | 0.34 | 77 | ○ | ○ |
| Comparative Example 1 | 25 | 269 | 2,200 | 0.03 | 84 | ○ | × |
| Comparative Example 2 | 25 | 327 | 3,400 | 0.04 | 60 | ○ | × |
| Comparative Example 3 | 25 | Undissolvable | 3,800 | 0.05 | 40 | ○ | × |
| Comparative Example 4 | 50 | Undissolvable | 3,300 | 0.34 | ○ | × | ○ |

The backgrinding tapes of Examples 1 to 3 each achieved both of heat resistance and excellent UV curability. Accordingly, the tapes were each able to be suitably used even in a high-vacuum and high-temperature process.
The backgrinding tape according to at least one embodiment of the present invention can be suitably used in the processing of a semiconductor wafer.

**Claims**

1.  A backgrinding tape, comprising:

    a base material; and
    a pressure-sensitive adhesive layer formed on one surface of the base material,
    wherein the base material has a flexural rigidity of 0.2 N·mm$^2$ or more, and a light transmittance of 10% or more at a wavelength of 400 nm, and
    wherein a resin forming the base material has a melting point of 200°C or more.

2.  The backgrinding tape according to claim 1, wherein the base material has a tensile modulus of elasticity of 1,500 MPa or more.

3.  The backgrinding tape according to claim 1 or 2, wherein the base material has a thickness of from 30 $\mu$m to 200 $\mu$m.

4.  The backgrinding tape according to any one of claims 1 to 3, wherein the resin forming the base material comprises at least one selected from the group consisting of a polyethylene terephthalate resin, a polyimide-based resin, a polyether ether ketone resin, a polyamide-imide resin, a polyethylene naphthalate resin, a polyphenyl sulfide resin, and a polyether-imide resin.

5.  The backgrinding tape according to any one of claims 1 to 4, wherein the pressure-sensitive adhesive layer is formed of an active energy ray-curable pressure-sensitive adhesive composition.

[Fig.1]

100

10

20

Europäisches
Patentamt
European
Patent Office
Office européen
des brevets

# EUROPEAN SEARCH REPORT

**Application Number**

EP 20 16 3866

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 309 822 A1 (MITSUI CHEMICALS TOHCELLO INC [JP]) 18 April 2018 (2018-04-18) * paragraph [0001]; claims; figure 1; examples 1,5,7; table 1 * ----- | 1-5 | INV. C09J7/25 H01L21/683 |
| X | DATABASE WPI Week 201707 9 June 2015 (2015-06-09) Thomson Scientific, London, GB; AN 2017-02384A XP002799951, -& JP 2017 005072 A (NITTO DENKO CORP) 5 January 2017 (2017-01-05) * abstract * ----- | 1-5 | |
| X | US 2010/252185 A1 (KIUCHI KAZUYUKI [JP] ET AL) 7 October 2010 (2010-10-07) * paragraphs [0001], [0006], [0160] - [0162]; example Production example 3 * ----- | 1-5 | |
| T | 4 Toray Ind. ET AL: , 1 January 2020 (2020-01-01), XP055720709, Retrieved from the Internet: URL:https://catalog.ulprospector.com/Datasheet.aspx?I=83754&FMT=PDF&E=303292 [retrieved on 2020-08-06] * the whole document * ----- | 1-5 | **TECHNICAL FIELDS SEARCHED (IPC)** C09J H01L |

The present search report has been drawn up for all claims

| Place of search | Date of completion of the search | Examiner |
|---|---|---|
| Munich | 6 August 2020 | Fodor, Csaba |

EPO FORM 1503 03.82 (P04C01)

## ANNEX TO THE EUROPEAN SEARCH REPORT
## ON EUROPEAN PATENT APPLICATION NO.

EP 20 16 3866

This annex lists the patent family members relating to the patent documents cited in the above-mentioned European search report.
The members are as contained in the European Patent Office EDP file on
The European Patent Office is in no way liable for these particulars which are merely given for the purpose of information.

06-08-2020

| Patent document cited in search report | | Publication date | Patent family member(s) | Publication date |
|---|---|---|---|---|
| EP 3309822 | A1 | 18-04-2018 | CN 107735855 A | 23-02-2018 |
| | | | EP 3309822 A1 | 18-04-2018 |
| | | | JP 6652563 B2 | 26-02-2020 |
| | | | JP WO2016199819 A1 | 11-01-2018 |
| | | | KR 20180011178 A | 31-01-2018 |
| | | | SG 11201708565R A | 29-11-2017 |
| | | | TW 201718796 A | 01-06-2017 |
| | | | US 2018158697 A1 | 07-06-2018 |
| | | | WO 2016199819 A1 | 15-12-2016 |
| JP 2017005072 | A | 05-01-2017 | NONE | |
| US 2010252185 | A1 | 07-10-2010 | CN 101857779 A | 13-10-2010 |
| | | | JP 2010241967 A | 28-10-2010 |
| | | | KR 20100111623 A | 15-10-2010 |
| | | | TW 201043471 A | 16-12-2010 |
| | | | US 2010252185 A1 | 07-10-2010 |

EPO FORM P0459

For more details about this annex : see Official Journal of the European Patent Office, No. 12/82

**EP 3 712 221 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011151163 A